# EUROPEAN PATENT APPLICATION

(11) **EP 1 246 325 A2**
(43) Date of publication of application: **02.10.2002**
(21) Application number: 02006503.3
(22) Date of filing: 18.03.2002
(51) Int. Cl.: H01S 5/02, B23K 26/00

(54) **Laser working dielectric substrate and method for working same and semiconductor package and method for manufacturing same**

(30) Priority: 22.03.2001 JP 2001082155; 14.02.2002 JP 2002036514
(71) Applicant: MATSUSHITA ELECTRIC INDUSTRIAL CO., LTD., Kadoma-shi, Osaka 571-8501 (JP)
(72) Inventor: Ogura, Hiroshi, Machida-shi, Tokyo 195-0061 (JP); Yoshida, Yoshikazu, Kawagoe-shi, Saitama 350-0042 (JP)
(74) Representative: Holmes, Miles

(57) **Abstract**

A dielectric substrate for laser working contains a substance having a size of a half to 10 times of a laser light wavelength and different in refractive index from a material of the dielectric substrate. This substance enhances the absorption of a laser beam. Due to this, the energy loss in laser beam is transformed into the heat of fusion to form a penetration hole, thereby forming a well-formed penetration hole. The substance different in refractive index from the dielectric substrate material uses bubbles when the dielectric substrate is a quartz glass substrate, and a glass bead or fiber when it is a resin substrate.

## Description

### FIELD OF THE INVENTION

The present invention relates to a dielectric substrate suited as a high-frequency circuit substrate requiring low dielectric loss and method for working same and to a semiconductor package utilizing it and method for manufacturing same and, more particularly, to a dielectric substrate for use in a circuit on a high-frequency band including a micro-or-millimeter wave and method for working same and to a semiconductor package and method for manufacturing same.

### BACKGROUND OF THE INVENTION

The substrate, for use in a high-frequency circuit on a micro-or-millimeter wave, is desirably formed of a material having, as a material characteristic of a substrate, a low dielectric loss in order to suppress the dielectric loss due to the substrate per se in the circuit.

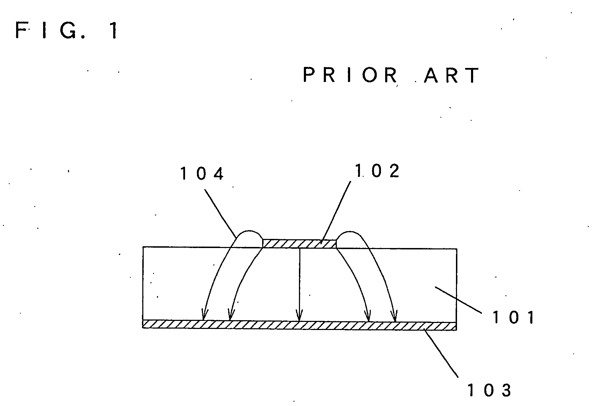

Fig. 1 is an explanatory view showing an effect of dielectric loss a high-frequency circuit substrate itself possesses in its nature upon a signal flowing through a transmission line. When an electric signal flows on the transmission line 102, the electric line of force 104 passes an interior of a substrate 101 to reach a ground electrode 103. On this occasion, the electric line of force 104 undergoes an affection of the dielectric loss the substrate 101 inherently possesses (given in a value of dielectric tangent).

The loss on the transmission' line 102 is expressed by:
loss = coefficient × frequency of a circuit under handled × (dielectric coefficient of the substrate 101)^{1/2} × dielectric loss of the substrate 101 (dielectric tangent).
The loss in this case turns into heat energy, causing a phenomenon to generate heat upon the substrate 101. Consequently, the substrate for use in the high-frequency circuit is selected to have a characteristic low in dielectric coefficient and dielectric loss.

The general organic material, e.g. glass-epoxy, exhibits a low dielectric constant and loss characteristic at low frequency. However, the dielectric constant conspicuously worsens at a micro or millimeter wave band of 1 GH₂ or longer, due to the relationship between potential polarization in the material and frequency response. For this reason, there are less cases of the use as a substrate for high-frequency (approx. 1 GHz or higher) applications. It is the general practice to use an inorganic material, such as alumina (dielectric constant: approx. 9, dielectric tangent: approx. 0.001), zirconia (dielectric constant: approx. 8, dielectric tangent: approx. 0.001) and aluminum nitride (dielectric constant: approx. 8, dielectric tangent: approx. 0.001).

On the other hand, as compared with the abovedescribed inorganic materials, glass such as quartz is low in dielectric constant (dielectric constant: approx. 4) and dielectric loss (dielectric tangent: 0.001 or less), and hopeful as a material of a high-frequency circuit substrate. However, conventionally there have been less cases to use glass for a high-frequency circuit substrate because of difficulty in partly working a through-holes or the like required in a circuit substrate.

However, the high-frequency circuit on a micro and millimeter wave band, in a communication system to radiocommunicate a great deal of information including moving pictures, has an extremely high frequency band. When using the above inorganic material, thermal loss is not negligible. For this reason, it is preferred to use, as a substrate material, glass such as quartz having a further low dielectric constant and loss.

In the case of using glass as a substrate material, the means for forming a penetration hole through the glass substrate includes ultrasonic working, etch working, sandblast working and laser working. In ultrasonic working, however, the tool is to be worn during working and limited in its size despite the capability of realizing the formation of a multiplicity of holes at one time.

In etch working, glass is materially stable and to be etched with a solution of hydrogen fluoride, phosphoric acid or alkali. However, the etch rate is extremely low, i.e. approximately 1 µm/h.

Sandblast working generally allows for working of maximally about two times a mask thickness in a depth direction. Accordingly, ultrasonic working, etching working and sandblast working, in any, are not suited as a method to form penetration holes through a glass substrate.

On the other hand, laser working is used in a massproducing process to form penetration holes or the like in an alumina substrate, and is free from substrate-size restriction. Accordingly, it is a working method suited for general substrate working. However, laser working when applied on glass substrates includes the following problems.

In the case the working technique using a CO₂ laser (wavelength: 10.6 µm), to be used in forming a penetration hole in an alumina substrate or the like, is applied in forming a penetration hole in a glass substrate, the major part of photon energy is absorbed as heat in the glass asubstrate to effect thermal working due to instantaneous fusion and evaporation. This, accordingly, inflicts thermal effects upon the peripheral region of laser light irradiation, thus leaving a hole form worked uneven.

In glass substrate working by an excimer laser, when a quartz glass having a thickness of 500 µm was worked by using a KrF excimer laser (wavelength: 0.248 µm), a penetration hole could be formed having a diameter of approximately 100 µm at an energy density of approximately 25 J/cm². However, no working was made at an energy density lower than the above. Conversely, where higher than that energy density, large cracks are caused in the glass substrate. Thus, the allowableness in working conditions is extremely narrow, making not suitable in view of the application as a glass substrate working method to a mass-production process.

It is to be expected that the use of an F₂ excimer laser (wavelength: 0.157 µm) shorter in wavelength than a KrF excimer laser somewhat moderates the narrowness in allowableness of working conditions on the glass substrate. However, F₂ gas is toxic to the human body. It is not preferred to use an F₂ excimer laser on a mass-production process.

Meanwhile, where working a glass substrate by using a ultra-short pulse laser of so-called a femtosecond laser having a pulse width of 10⁻¹³ seconds or less, the glass substrate can be worked as demonstrated, e.g. in the magazine "Materials Integration Vol.13 No.3 (2000)" pp.67-73. However, a ultra-short pulse laser system is expensive and high in running cost, hence being difficult in application to a mass-production process.

YAG laser (wavelength: 1.06 µm) can work a finer shape than CO₂ laser working, in working a glass-epoxy substrate or the like due to the recent requirement for microfabrication. In place of CO₂ laser working, this has being placed into practical use. Because of lower in price and running cost than the other laser working systems, the working means is suited for mass production. However, because YAG laser has a wavelength (1.06 µm) to transmit through glass, it is not absorbed in glass and difficult in application to glass working. If energy density is raised in order to cause multiphoton absorption, cracks take place in the glass thus making impossible to obtain favorable worked form.

### SUMMARY OF THE INVENTION

The present invention has been made in view of the foregoing points, which provides a dielectric substrate and method for working same capable of coping with mass-production processing, in working a dielectric substrate such as a glass substrate and a resin substrate by the use of a laser. More particularly, it is an object to provide a dielectric substrate which is to be worked by using a YAG laser low in price and running cost, and a method for working same.

Meanwhile, it is an object of the invention to provide a high-performance, inexpensive semiconductor package using a dielectric substrate having an extremely low dielectric constant and loss, particularly a semiconductor package that is extremely low in heat loss, high in performance but excellent in mass producibility and suited for a high-frequency circuit on a high frequency band including micro and millimeter wave bands, and manufacturing method for same.

In order to solve the problem, the invention has a dielectric substrate for laser working containing a substance having to of a laser light wavelength and different in refractive index from a material of the dielectric substrate, thereby improving the efficiency and form in laser working a dielectric substrate.

Meanwhile, the invention has a quartz substrate containing therein bubbles, thereby further improving a high-frequency material characteristic of the substrate itself and improving the workability in forming a throughhole owing to bubble containment.

Meanwhile, by using such a dielectric or quartz substrate, realized is an inexpensive, high-performance semiconductor package for high frequency applications.

### BRIEF DESCRIPTION OF THE DRAWINGS

Fig. 1 is a sectional view showing a state of an electric line of force when a conventional dielectric substrate is laser-worked;
Fig. 2 is a sectional view of a glass substrate, in laser working, containing bubbles in a quartz substrate according to first and second embodiments of the invention, wherein Fig. 2A is prior to working while Fig. 2B is after working;
Fig. 3 is an illustrative view of a scanning electronic microscopic picture showing a worked result of the quartz substrate according to the second embodiment of the invention and an enlarged view of a penetration hole;
Fig. 4 is a scanning electron microscopic picture showing a worked result of a quartz substrate under the condition different from that of Fig. 3 in the second embodiment of the invention;
Fig. 5 is a sectional view showing the general state in laser-working a resin substrate;
Fig. 6 is a sectional view showing a laser-working state of a resin substrate according to a third embodiment of the invention, wherein Fig. 6A is prior to working while Fig. 6B is after working;
Fig. 7 is a sectional view showing a working principle of a resin substrate according to the second embodiment of the invention;
Fig. 8 is a sectional view showing a working method of a resin substrate according to the third embodiment of the invention, wherein Fig. 8A is prior to working while Fig. 8B is after working;
Fig. 9 is a sectional view explaining a laser working principle of a resin substrate according to the third embodiment of the invention;
Fig. 10 is a sectional view of a semiconductor package according to a fourth embodiment of the invention;
Fig. 11 is a view showing a structure of a semiconductor package according to a fifth embodiment of the invention, wherein Fig. 11A is a plan view while Fig. 11B is a sectional view.

### DESCRIPTION OF THE EXEMPLARY EMBODIMENT

Exemplary embodiments of the present invention are demonstrated hereinafter with reference to the accompanying drawings.

### 1. First Exemplary Embodiment

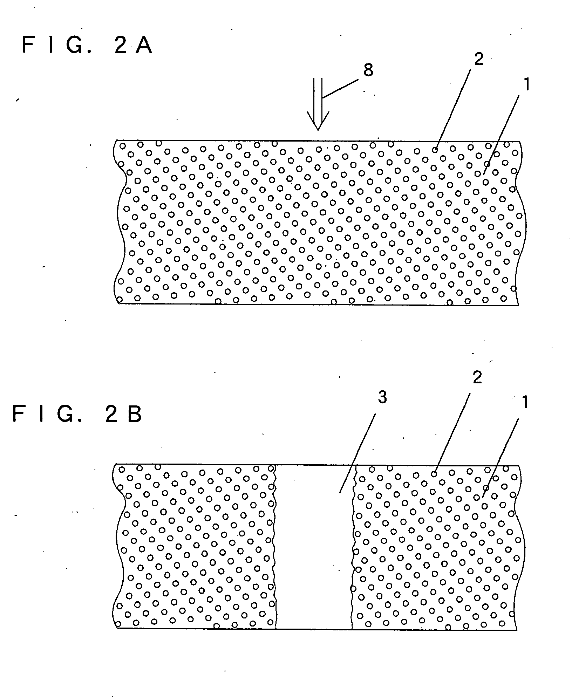

Fig. 2 shows a sectional view of a glass substrate in a laser-working wherein a glass substrate 1 of quartz or the like contains bubbles 2. Fig. 2A represents a state prior to the laser working while Fig. 2B a state after laser working. The bubbles 2 are usually contained in such a manner that the bubbles 2 are scattered at random in the glass substrate 1. By irradiating a laser beam 8 to a glass substrate 1 containing bubbles 2, a penetration hole 3 is formed in the glass substrate 1 by laser working. The penetration hole 3 is nearly linearly formed extending along an irradiation direction of the laser beam 8, having a conspicuously improved form. The reason why laser workability on the glass substrate 1 containing bubbles 2 is improved is due to the following. Namely, simultaneously with thermal working on the glass by laser irradiation, fine cracks are caused between fine bubbles in the glass with respect to the irradiating direction of the laser beam 8 so that the cracks successively propagate in a direction of from a laser irradiation surface toward the opposite surface to the laser irradiation, thereby causing the phenomenon of working.

As already noted, quartz is superior in high frequency characteristic to alumina generally used as .a dielectric substrate material for high-frequency applications. The high frequency characteristic can be further improved by the containment of bubbles. This is because air in the bubble is an ideal dielectric which has a dielectric constant of 1 and a dielectric loss of 0. By containing bubbles in quartz, the apparent dielectric constant and loss of the material is made to a lower value than that of quartz in a singular form.

Table 1 shows an example of the working conditions under which various laser have been used to form a penetration hole through a 1-mm-thick quartz glass spotted with bubbles of 1- 90 µm.

**TABLE 1.**

| Working Conditions of Bubble-contained Quartz Glass by Various Lasers | | | | |
|---|---|---|---|---|
| Laser scheme | Wavelength | output form of Laser | Power | Shots |
| RF excited CO₂ laser | 10.6µm | Pulse (pulse width: 10msec) | 200W | 1 shot |
| YAG laser | 1.06µm | Pulse (pulse width: 500 µsec.) | 1.1J | 5 shots |
| Semiconductor diode laser | 0.81µm | Continuous | 470W | 3 seconds |

As can be seen from Table 1, a penetration hole can be formed in the bubble-containing quartz glass by an RF excited CO₂ laser, a YAG laser or a semiconductor diode laser.

The result of working under the conditions shown in Table 1 shows that the bubble-containing quartz glass is excellent in workability. This result will be explained in detail below.

First, concerning penetration-hole working by a CO₂ laser, it is impossible, with a small energy of the CO₂ laser as shown in Table 1, to form a penetration hole not only in the usual quartz glass but also in alumina. On the other hand, the reason why the bubble-containing quartz glass can be worked at a low energy as shown in Table 1 is due to the following. Namely, a laser beam at low energy first causes fine cracks in the bubble-containing quartz glass and then the cracks successively propagate through fine bubbles, thereby accelerating the working. Incidentally, the working surface is extremely smooth because of laser irradiation and, at the same time, almost free of deterioration due to heat at or around the penetration hole to be caused in usually working quartz glass by a CO₂ laser. This can be considered because the bubbles in quartz glass provide an adiabatic effect to prevent the generated heat from spreading.

Meanwhile, the usual quartz glass cannot be worked by a YAG laser whereas the bubble-containing quartz glass can be worked by a YAG laser. This is because the usual quartz glass has an optical characteristic that, at a YAG laser wavelength of 1.06 µm, energy absorption does not occur but the major part of energy transmits. On the contrary, by containing bubbles in quartz glass, the absorption-wavelength characteristic of the usual quartz glass can be changed to enable working.

### 2. Second Exemplary Embodiment

The bubble-containing quartz glass explained in Embodiment 1, although effective in working with a CO₂ laser, has a somewhat problem when worked by a YAG laser more inexpensive than a CO₂ laser. This is because the YAG laser is lower in output energy than the CO₂ laser. For this reason, this embodiment is set with the following conditions for the bubbles to be mixed in quartz glass.

Table 2 shows the working conditions on bubblecontaining glass substrate by a YAG laser.

**TABLE 2.**

| Working Conditions on Bubble-containing Glass by a YAG Laser | | | | |
|---|---|---|---|---|
| | Bubble size | Volume content ratio of bubbles | YAG laser workability | Corresponding figure |
| Sample A | 0.1∼0.5µm | Approx. 10% | Only crater formed | Fig. 4 |
| Sample B | 2.0∼5.0µm | Approx. 5% | Penetration hole formed | Fig. 3 |
| Sample C | 100∼200µm | Approx. 12% | Not formed | ---- |

The working condition shown in Table 2 is under that three 1-mm-thick quartz glass plates (Sample A, Sample B and Sample C) different in bubble size and content ratio were prepared, and worked by irradiating a YAG laser having a wavelength of 1.06 µm. Sample A has a bubble size of 0.1 µm - 0.5 µm and a volume content ratio of bubbles of approximately 10%, Sample B has a bubble size of 2.0 µm - 5.0 µm and a volume content ratio of bubbles of approximately 5%, and Sample C has a bubble size of 100 µm - 200 µm and a volume content ratio of bubbles of approximately 12%.

In the YAG laser working on the Sample B, a penetration hole having a diameter of 100 µm could be opened by one pulse of a laser having a pulse width of 0.5 msec and a power of 0.8J. Meanwhile, with a longer pulse width or higher power than that condition, a penetration hole could be opened. The quartz glass in this case has a section as shown in Figs. 2A and 2B. Fig. 2A is a state prior to laser working while Fig. 2B a state after laser working.

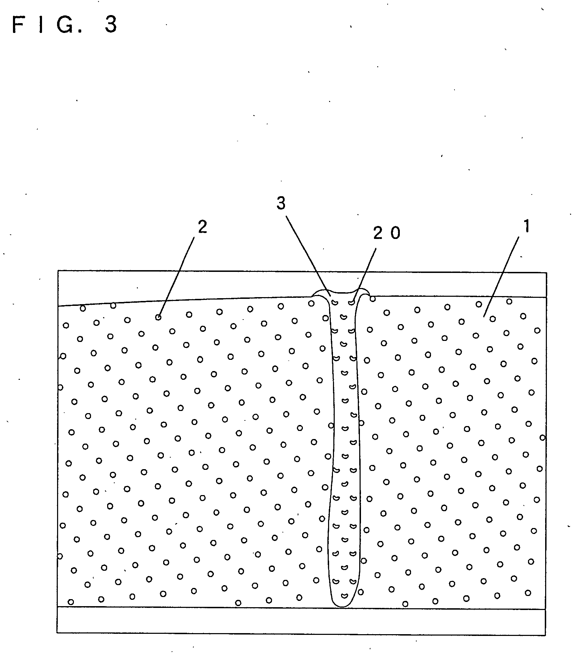

Fig. 3 is a detailed view of a penetration hole worked by a YAG laser on the Sample B, which is an illustrative view of a section of a scanning electronic microscope picture of a penetration hole formed by one pulse of a YAG laser having a pulse width of 0.8 msec. and a power of 1.0J. In the glass substrate 1 containing bubbles 2, a penetration hole 3 is formed nearly in a straight line form extending along a direction of laser light irradiation. Bubbles 20 in a semi-fused state are formed in an inner wall of the penetration hole 3.

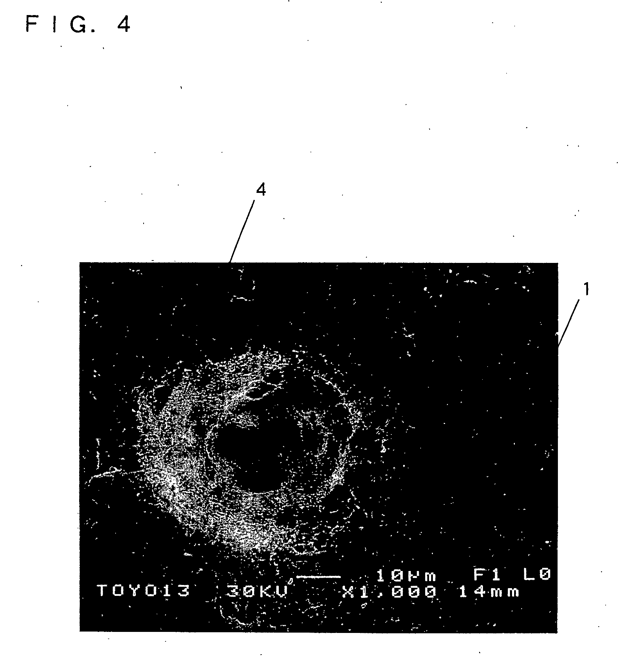

On the contrary, in an experiment on Sample A, a penetration hole could not be formed even with a power raised up to 3.0J of a YAG laser having a pulse width of 1.0 msec. Meanwhile, despite shots were raised up to 10 pulses in order to improve the workability, nothing was produced more than a crater having a depth of ten µm. Fig. 4 is an example of laser working on Sample A, which is a scanning electronic microscopic picture as observed a laser working state from above. This shows a state that a crater 4 is formed in an upper surface of the glass substrate 1.

In an experiment on Sample C, despite a YAG laser output was raised up to a power similarly to that of Sample A, working could not be made wherein the state remained in a degree no working flaws could not be observed by the scanning electron microscope.

Sample A and Sample B contain bubbles in a size of from one-tenth to ten times a laser light wavelength. It is to be presumed that the working by the YAG laser on these samples be made by the occurrence of laser beam 8 absorption owing to the size of bubbles. On the other hand, it can be considered that, on Sample C, the bubbles 2 be too large to cause absorption of the laser beam 8 when worked by a YAG laser.

On Sample A, however, YAG laser working caused a crater but could not form a penetration hole. It can be considered that this is because the bubbles 2 in Sample A are to small so that, when the glass substrate 1 is locally fused immediately after irradiating the laser beam 8 to the surface of the glass substrate 1, the bubbles 2 close to the surface of the glass substrate 1 vanish to prevent the laser beam 8 from being absorbed in a lower region than the surface of the glass substrate 1.

On the contrary, in the working on Sample B, the bubbles 20 in a semi-fused state are observed in an innerwall surface of the penetration hole 3 as can be seen in Fig. 3. It can be presumed that all the bubbles 2 will not vanish in the YAG laser working with a result that hole working is favorably made. Accordingly, it can be seen that, in YAG laser working, the size of the bubbles 2 existing in the glass substrate 1 dominates workability. The bubble size in Sample B is 2.0 - 5.0 µm. When the bubble size was changed centering on that range, it was confirmed that, where containing bubbles 2 in a size of approximately one-second (0.5 µm) to ten times (10 µm) of a laser wavelength (1.06 µm), workability is improved to form a penetration hole.

Meanwhile, concerning the volume content ratio of bubbles 2 in the glass substrate 1, it was confirmed that the volume content ratio of bubbles is desirably 5% or higher from the fact that, in the working of Sample B, YAG laser working on the glass substrate 1 was confirmed at a content ratio of bubbles 2 of approximately 5%. It can be presumed that laser working is easier as the content ratio of bubble 2 increases. However, in the case the content ratio of bubbles 2 is excessively high, the glass substrate 1 itself is ready to be broken. Consequently, the bubble content is practically limited generally to approximately 50%. On the other hand, in the case the bubble content ratio is lower than 5%, even if a low energy laser beam causes fine cracks in the glass substrate, the cracks are less propagated to the other bubbles due to low amount of bubbles thus decelerating laser working. Accordingly, the volume content ratio of bubbles 2 is practically in a range of 5 - 50%.

The above result of working is on the case with a YAG laser basic wave (wavelength: 1.06 µm). The similar effect is available in the laser working employing a YAGlaser second harmonic (wavelength: 0.532 µm) or third harmonic (wavelength: 0.355 µm), by providing the similar relationship of a bubble size with a laser light wavelength.

As described above, the present embodiment can work a quartz glass substrate generally having difficulty in working by the use of an inexpensive YAG laser, enabling quartz substrate working excellent in mass producibility. Consequently, it is possible to inexpensively obtain a dielectric substrate extremely low in dielectric constant and loss preferable for a high-frequency circuit substrate for micro-or-millimeter wave applications. Thus, the use of the dielectric substrate provides a high-frequency circuit extremely low in heat loss.

Incidentally, the quartz glass substrate containing bubbles in the embodiment can be favorably worked at low cost similarly to that with a YAG laser, by the use of an excimer laser, such as an ArF laser, a KrF laser or an F₂ laser, instead of a YAG laser.

### 3. Third Exemplary Embodiment

The dielectric substrate working using a laser of the invention can realize the working to cause the similar effect on a dielectric substrate mixed with fine particles in a resin substrate, besides the working on the quartz glass substrate as described in Embodiments 1 and 2.

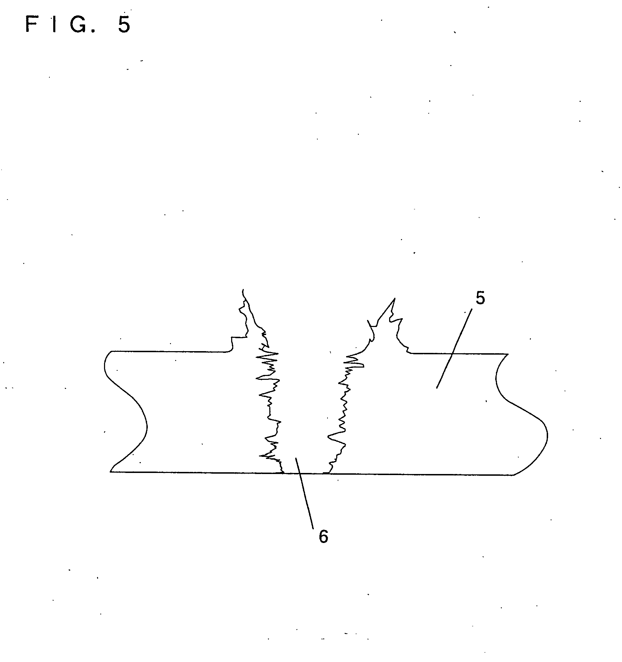

For example, the resins, such as polyimide, liquid-crystal polymer, benzocyclobutene and PPE (polyphenyle ether), are known as dielectric materials having low dielectric constant and loss. Nevertheless, in the case of working such a resin substrate by a YAG laser, the penetration hole 6 formed in a resin substrate 5 will be uneven in shape as shown in Fig. 5. However, in order to avoid an uneven form of a penetration hole 6 in a resin substrate 5, the workability with a YAG laser can be improved by containing fine particles in the resin substrate 5.

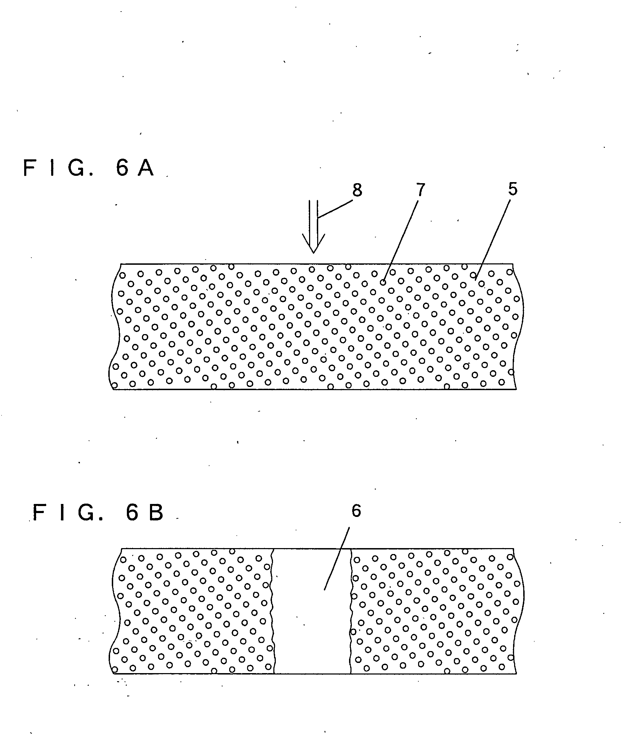

Fig. 6 shows a typical view that fine particles are contained in a resin substrate to improve YAG laser workability. Fig. 6A is a sectional view in a state prior to laser working while Fig. 6B is a sectional view in a state of after laser working. A fine glass bead 7 is contained as fine particles in a resin substrate 5. In the case that this irradiated by a laser beam 8 as a working beam, a penetration hole 6 is formed nearly in a straight-line form extending along a direction of incidence of a laser beam 8. The glass bead 7 mixed in the resin substrate 5 is desirably in a spherical form having a size of a half to 10 times of a laser wavelength, particularly having a diameter nearly the same as the laser light wavelength. The containment of glass bead 7 in the resin substrate 5 also serves to lower (or worsen) the apparent thermal conductivity of the resin substrate 5.

The reason why the YAG laser workability is improved by containing glass bead 7 in the resin substrate 5 is as follows. Namely, when irradiating a laser beam 8, absorption of laser beam 8 takes place in the glass bead 7 itself and at an interface between the glass bead 7 and the resin of resin substrate 5 rather than in the other region. As a result, the heat of fusion occurs much more than in the other region.

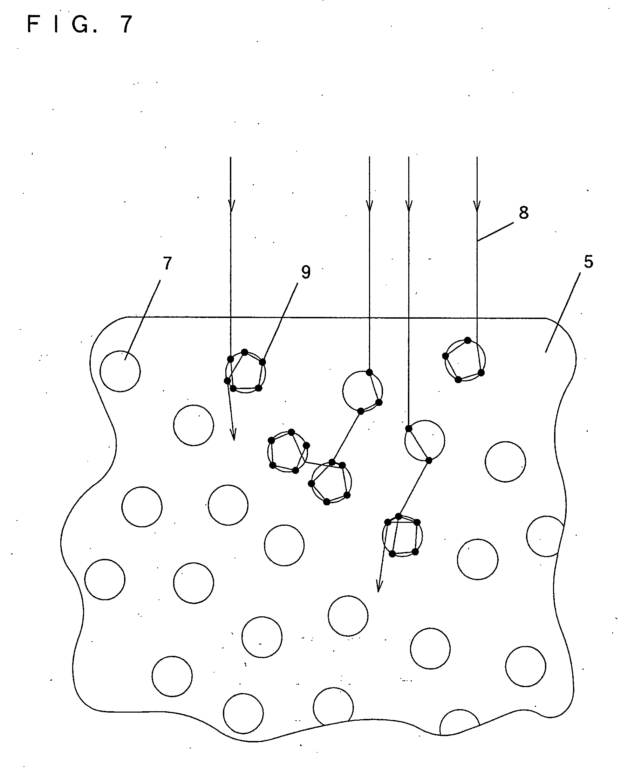

Fig. 7 is a view for explaining the principle of working. When a laser beam 8 is irradiated to the resin substrate 5 and the laser beam 8 is incident on the glass bead 7, the laser beam 8 refracts in plurality of times within the glass bead 7 depending upon an angle of incidence on the glass bead 7. Each time of refraction, the laser beam 8 loses its energy at an interface 9 between the glass bead 7 and the resin. The energy loss turns into heat to cause heat generation. The heat generating action causes fusion in the glass bead 7 and its periphery. However, in the region the laser beam 8 is not irradiated, thermal conductivity is worsened by the existence of glass bead 7 to reduce the diffusion of heat. As a result, removal is only in the region irradiated by the laser beam 8. Because the phenomenon takes place continuously in the region being irradiated by the laser beam 8, a desired linear form of hole working is realized avoiding the uneven form of penetration hole.

Incidentally, in the case that the glass bead 7 is excessively large in size for a wavelength of the laser beam 8, the diffusion of heat takes place only within the glass bead 7, thus making impossible to achieve favorable hole working. Meanwhile, where the glass bead 7 is excessively small for a wavelength of the laser beam 8, no energy absorption occurs in the glass bead 7, making impossible to achieve favorable hole working. On the other hand, where the diameter of glass bead 7 is in a size of a half to 10 times of a wavelength of the laser beam 8, sufficient light absorption and heat generation take place for hole working thus making possible to favorable hole working.

As described above, this embodiment can work a resin substrate generally difficult in favorable hole working by the use of an inexpensive YAG laser, thereby enabling resin substrate working excellent in mass producibility. Consequently, it is possible to obtain, at low cost, a resin substrate extremely low in dielectric constant and loss preferable as a high-frequency circuit substrate for micro-or-millimeter wave applications. Therefore, the use of the resin substrate provides a high-frequency circuit extremely low in heat loss.

Note that the resin substrate in this embodiment can be favorably worked at low cost similarly to a YAG laser,. by the use of an excimer laser, such as an ArF laser a KrF laser and an F₂ laser, besides a YAG laser.

### 4. Fourth Exemplary Embodiment

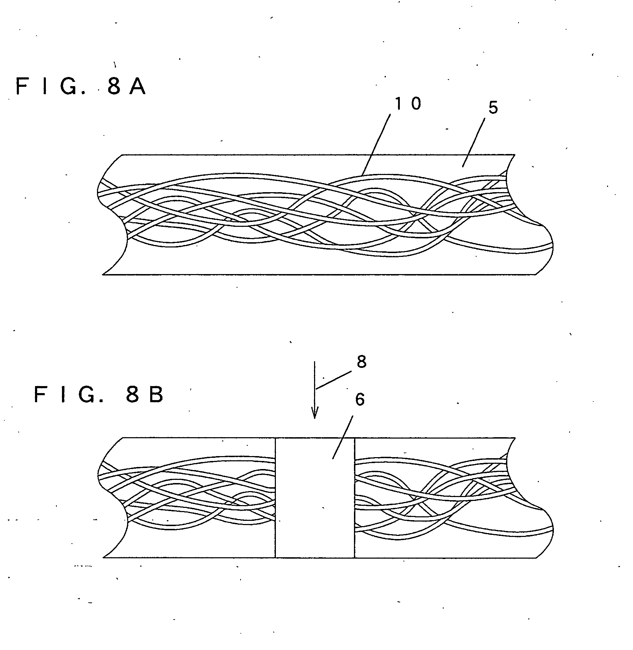

The improvement in laser workability on a resin substrate with using a YAG laser can be realized also by containing a glass fiber in the resin substrate. Fig. 8 shows a typical view that a glass fiber is contained in a resin substrate to improve YAG laser workability. Fig. 8A is a sectional view in a state of prior to laser working while Fig. 8B is a sectional view in a state of after laser working. By containing a glass fiber 10 in a resin substrate 5 to irradiate to this a laser beam 8 as a working beam, a penetration hole 6 is formed nearly in a straight-line form extending along a direction of incidence of the laser beam 8. The sectional diameter of the glass fiber 10 is desirably a half to 10 times of a wavelength of laser light, particularly nearly the same as a wavelength of laser light.

The reason why YAG laser workability is improved by containing a glass fiber 10 in the resin substrate 5 is as follows. Namely, when irradiating a laser light 8, absorption of laser light 8 takes place in the glass fiber 10 itself and at an interface between the glass fiber 10 and the resin of resin substrate 5 rather than in the other region. As a result, the heat of fusion occurs much more than in the other region.

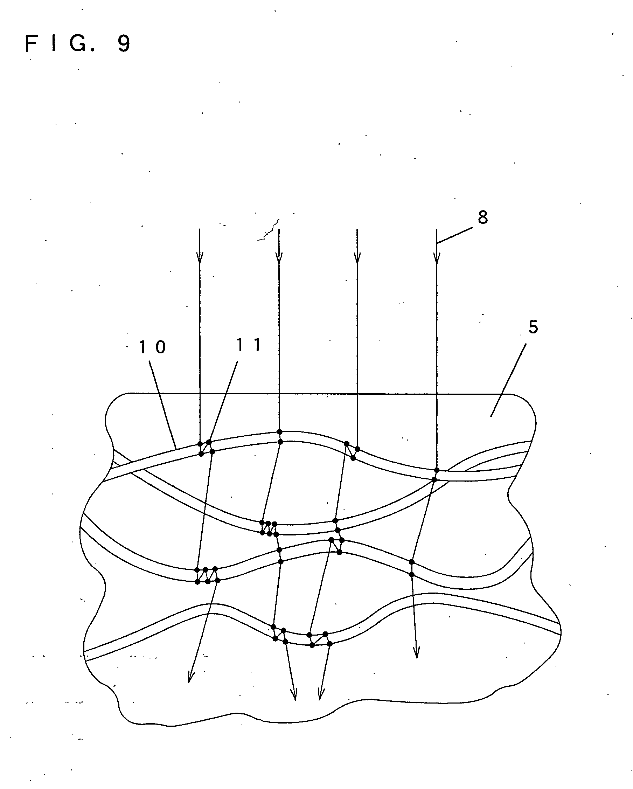

Fig. 9 is a view for explaining the principle of working. When a laser beam 8 is irradiated to the resin substrate 5 and the laser beam 8 is incident on the glass fiber 10, the laser beam 8 refracts in plurality of times within the glass fiber 10. Each time of refraction, the laser beam 8 loses its energy at the interface 11 between the glass fiber 10 and the resin. The energy loss turns into heat to cause heat generation. The heat generating action causes fusion in the glass fiber 10 and its periphery. As a result, removal is only in the region irradiated by the laser beam 8. Because the phenomenon takes place continuously in the region being irradiated by the laser beam 8, a desired form of worked hole is realized avoiding an uneven form of penetration hole.

Incidentally, in the case that the glass fiber 10 herein is excessively large in sectional diameter size for a wavelength of the laser beam 8, the diffusion of heat occurs only within the glass fiber 10, thus making impossible to achieve favorable worked hole. Meanwhile, where the glass fiber 10 in its sectional diameter is excessively small for a wavelength of the laser beam 8, no energy absorption occurs in the glass fiber 10, making impossible to achieve favorable worked hole. On the other hand, in the case that the sectional diameter of glass fiber 10 is in a size of a half to 10 times of a wavelength of the laser beam 8, sufficient light absorption and heat generation take place for cutting. This makes it possible to work a hole such that fibers of the glass fiber 10 do not leave.

As described above, this embodiment can work a resin substrate generally difficult in favorable hole working by the use of an inexpensive YAG laser, thereby enabling resin substrate working excellent in mass producibility. Consequently, it is possible to obtain, at low cost, a resin substrate extremely low in dielectric constant and loss preferable as a high-frequency circuit substrate for micro-or- millimeter wave applications. Therefore, the use of the resin substrate provides a high-frequency circuit extremely low in heat loss.

Note that the resin substrate in this embodiment also can be favorably worked at low cost similarly to a YAG laser, by the use of an excimer laser, such as an ArF laser, a KrF laser and an F₂ laser, besides a YAG laser.

### 5. Fifth Exemplary Embodiment

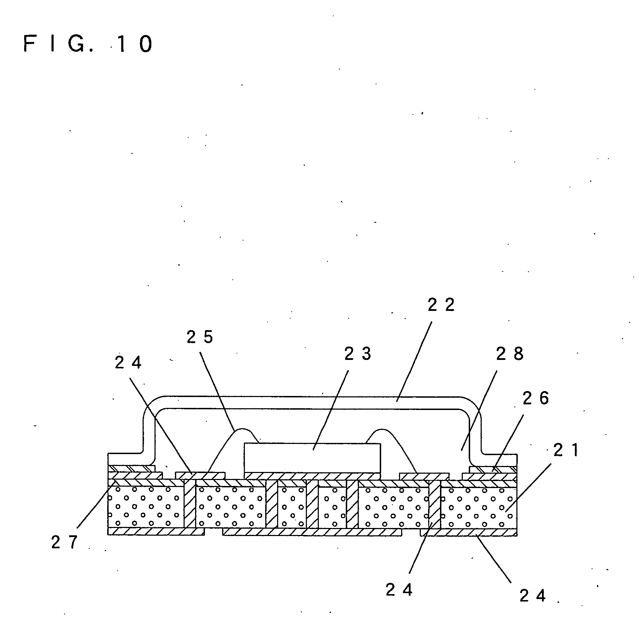

Fig. 10 shows one form of a semiconductor package structure using a dielectric substrate laser-worked in the invention. This embodiment is an example using, as a dielectric substrate, a quartz substrate containing bubbles. A thin insulator 27 is formed over a surface of a quartz substrate 21 mixed with bubbles, on which is formed a pattern of electrical interconnection 24a. The thin insulator 27 will be detailed later. On the other hand, a pattern of electrical interconnection 24b is formed on the other surface of the quartz substrate 21. The electrical interconnections 24a, 24b are connected together by an electrical interconnection 24c buried in a penetration hole opened in the quartz substrate 21 by the method of Embodiment 1 or 2. A semiconductor device 23 is arranged on the electric interconnection 24a and connected to the electrical interconnection 24a by a wire 25. A metal-make lid 22 is provided covering the semiconductor device 23 on the quartz substrate 21, in order for electromagnetic shield and hermetic seal. The lid 22 is bonded by a conductive adhesive 26 in order to be electrically connected to the quartz substrate 21. A space 28, formed between the quartz substrate 21 and the lid 22, is filled and hermetically sealed with a gas less reactive with other materials, e.g. vacuum or an inert gas of helium (He), argon (Ar) or the like or nitrogen (N₂).

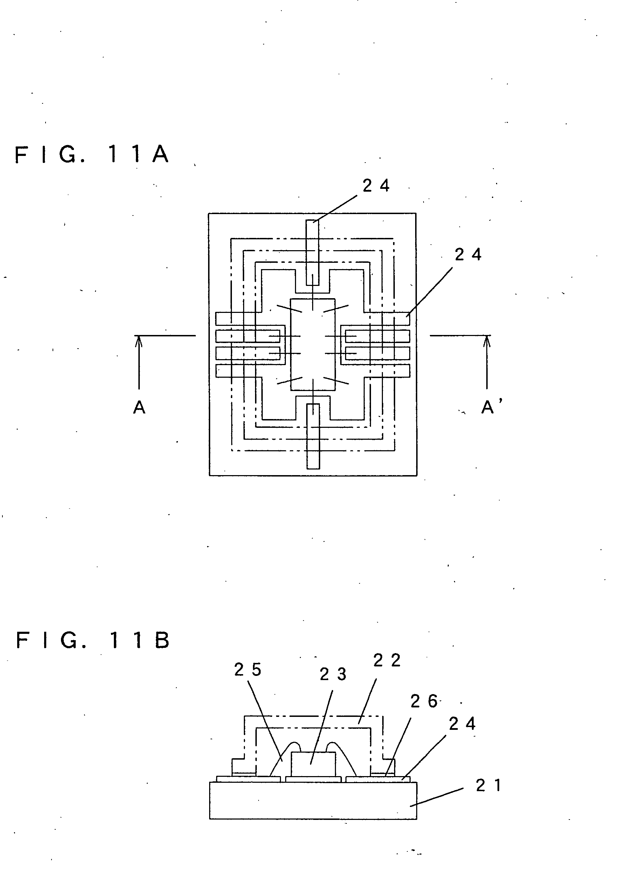

With a semiconductor package of Fig. 11, a semiconductor package can be realized which is well in high frequency characteristic, cheap in price and high in reliability. The reason why a semiconductor package having such a high frequency characteristic and low price lies in that the present embodiment employs a quartz substrate 21 mixed with bubbles in contrast to the general semiconductor package using an alumina substrate structure. This is because, as noted before, the quartz substrate 21 mixed with bubbles is superior in highfrequency characteristic to the alumina substrate and, moreover, is low in working cost in laser working.

Incidentally, by arbitrarily adjusting the amount of bubbles to be mixed in the quartz substrate 21, apparent dielectric constant and loss can be controlled for the bubble-mixed quartz substrate 21. Accordingly, this makes it possible to fabricate a semiconductor package having an electric characteristic as desired by a user. In this case, the amount of mixing bubbles is preferably adjusted within a range of volume content ratio of 5% to 50% because of the reason noted in Embodiment 1.

Meanwhile, in the case the bubbles contained in the quartz substrate 21 have a size of 10 µm or smaller, the obtainable electric characteristic can be suppressed in variation rather than the case of containing bubbles uneven in diameter. Furthermore, it is possible to considerably decrease the concavo-convex in a quartz surface of the quartz substrate 21 after being worked by using a laser.

Incidentally, although the laser for laser working is preferably a YAG or excimer laser in consideration of working cost, it may use a CO₂ laser or semiconductor diode laser as was explained in Embodiment 1.

The metal-make lid 22 is electrically grounded with the electric interconnection 24a on the quartz substrate 21 by a conductive adhesive 26. Accordingly, because the unwanted electromagnetic wave given off from the semiconductor device 23 is prevented from radiating and, conversely, the unwanted electromagnetic wave from the external is prevented from intruding, the high-frequency characteristic is further improved. In this case, the lid 22 even if structured of an insulator coated with a metal film other than the metal-make one can obtain the similar effect.

The reliability as semiconductor package is secured by hermetically sealing the interior of the package in a vacuum state or with an inert gas of helium(He), argon (Ar) or the like or nitrogen (N₂). This embodiment, however, has a thin insulator 27 arranged on the quartz substrate 21 in order to realize hermetic seal. This is to prevent against the lower in air-tightness due to containment of bubbles in the quartz substrate 21. The thin insulator 27 is an organic substance, e.g. polimide, benzocyclobuthene and liquid-crystal polymer. The thin insulator 27 can be formed by applying an insulator in a solution state to over the quartz crystal 21 by spin coating, by laminating a pre-formed insulator 27 in a sheet form by a laminator or by pressing it while applying heat.

Incidentally, the thin insulator 27 is formed extremely thin, i.e. 5 - 30 µm, as compared to the quartz substrate 21. This will not interfere with the penetration working in the quartz substrate 21 by laser working or the like. Meanwhile, the thin insulator 27 if formed thin of glass as an inorganic substance formable by spin coating (spin-on-glass called SOG or the like), besides of an organic substance, can obtain the similar effect.

Incidentally, although in Fig. 10 a wire 25 is used to electrically connect between the semiconductor device 23 and the electrical interconnection 24a, a small metal projection called bump may be formed on an electrode of the semiconductor device 23 or on the electrical interconnection 24a on the substrate end thereby connecting between the semiconductor device 23 and the electrical interconnection 24a.

The mounting method of such a semiconductor device 23 generally uses a technique called flip-chip mounting. With such electrical connection, because bump height is smaller than the wire length of wire connection, it is possible to shorten the connection distance between the semiconductor device 23 and the quartz substrate 21 and hence suppress a parasitic inductance component from occurring. This, accordingly, makes it possible to fabricate a semiconductor package higher in performance.

Incidentally, the quart substrate 21 can similarly use a quartz substrate mixed with bubbles in a size of a half to 10 times of a laser light wavelength as explained in Embodiment 2, besides a quartz substrate randomly mixed with bubbles in a size of 1 - 90 µm as explained in Embodiment 1. Meanwhile, in the case of using a resin substrate mixed with a fine particular matter,'such as a glass bead, or a glass fiber as explained in Embodiments 3 and 4, a semiconductor package can be obtained having the similar operation effect.

### 6. Sixth Exemplary Embodiment

Fig. 11 shows another embodiment of a semiconductor package structure employing a dielectric substrate laser-worked in the invention. Fig. 11A is a plan view of a semiconductor package as viewed from above while Fig. 11B is a sectional view taken on line A-A' in Fig. 11A. The difference from Fig. 10 lies in that the electrical interconnection 24 of the semiconductor package itself is arranged only on the upper surface of the quartz substrate 21 while, although not shown, the penetration hole in the dielectric substrate 21 is utilized for connection to another semiconductor package or component.

In the structure shown in Figs. 11A and 11B, in order to make the electric interconnection 24 and the metal-make lid 22 common only in ground, there is a need for the conductive adhesive 26 to be structurally out of contact with a high-frequency signal transmitting line and power supply line of among the electrical interconnections 24.

### 7. Seventh Exemplary Embodiment

A high-frequency circuit for micro-or-millimeter wave applications was fabricated as a semiconductor package of Embodiments 5 and 6. This high-frequency circuit, because low in substrate dielectric constant and loss, can reduce the heat loss on a transmission line and the heat generation on the substrate. Furthermore, because the substrate can be inexpensively laser-worked into favorable worked shape, it is possible to manufacture a circuit high in function and excellent in mass producibility.

Accordingly, the high-frequency circuit, applicable to wireless terminals, wireless base stations or radar devices, can provide a mass-producible device having high function.

## Claims

1. A dielectric substrate for laser working **characterized in that** a dielectric substrate contains a substance having a size of a half to 10 times of a wavelength of laser light and different in refractive index from a material of said dielectric substrate.

2. A dielectric substrate according to claim 1, wherein the substance different in refractive index from a material of said dielectric substrate is in a volume content ratio of 5% - 50%.

3. A dielectric substrate according to claim 1, wherein the dielectric substrate material is glass or resin.

4. A dielectric substrate according to claim 1, wherein the substance different in refractive index from a material of said dielectric substrate is bubble.

5. A dielectric substrate according to claim 3, wherein the resin is any one selected from polyimide, liquid-crystal polymer, benzocyclobutene and polyphenylene ether.

6. A dielectric substrate according to claim 1, wherein said dielectric substrate is of resin and the substance different in refractive index from a material of said dielectric substrate is a fine particle or a fiber.

7. A dielectric substrate according to claim 6, wherein a diameter of the fine particle or a sectional diameter of the fiber has a size substantially the same as a laser light wavelength.

8. A dielectric substrate according to claim 6, wherein the fine particle is a glass bead.

9. A dielectric substrate according to claim 6, wherein the fiber is a glass fiber.

10. A method for working a dielectric substrate **characterized in that** by a laser is formed a dielectric substrate containing a substance having a size of a half to 10 times of a wavelength of laser light and different in refractive index from a material of said dielectric substrate.

11. A method according to claim 10, wherein the laser is a YAG laser or an excimer laser.

12. A method according to claim 10, wherein the laser is a YAG laser using, as laser light, any of a basic wave, a second harmonic and a third harmonic.

13. A method according to claim 10, wherein the excimer laser is any one selected from an ArF laser, a KrF laser and an F₂ laser.

14. A semiconductor package having a semiconductor device provided on a substrate and sealed within a container, the semiconductor package **characterized in that** said substrate provided with said semiconductor device is a quartz substrate and said quartz substrate contains bubbles.

15. A semiconductor package according to claim 14, wherein the bubbles contained in said quartz substrate are arbitrarily controlled in amount.

16. A semiconductor package according to claim 14, wherein the bubbles contained in said quartz substrate are in a size of 10 µm or smaller.

17. A semiconductor package according to claim 14, wherein said substrate provided with said semiconductor device is a quartz substrate containing bubbles and formed thereon with a thin insulator.

18. A semiconductor package according to claim 17, wherein said thin insulator is an organic matter.

19. A semiconductor package having a semiconductor device provided on a substrate and sealed within a container, the semiconductor package **characterized in that** said substrate provided with said semiconductor device is a dielectric substrate and said dielectric substrate contains a substance having a size of a half to 10 times of a wavelength of laser light and different in refractive index from a material of said dielectric substrate.

20. A semiconductor package according to claim 19, wherein said dielectric substrate is a quartz substrate and the material different in refractive index from a material of said dielectric substrate is bubbles.

21. A semiconductor package according to claim 20, wherein the bubbles contained in said quartz substrate are in a volume content ratio of 5% - 50%.

22. A semiconductor package according to claim 20, wherein the bubbles contained in said quartz substrate are in a size of a half to 10 times of a laser wavelength.

23. A semiconductor package according to claim 14, wherein said semiconductor device is flip-chip-mounted on said quartz substrate.

24. A semiconductor package according to claim 23, wherein an electromagnetic shielding cap is arranged covering said semiconductor device on said quartz substrate.

25. A semiconductor package according to claim 24, wherein said electromagnetic shielding cap is a metal or insulator coated with a metal film.

26. A semiconductor package according to claim 19, wherein the dielectric substrate material is a resin of any one selected from polyimide, liquid-crystal polymer, benzocyclobutene and polyphenylene ether.

27. A semiconductor package according to claim 19, wherein said dielectric substrate is of resin and the substance different in refractive index from said dielectric substrate is a fine particle or a fiber.

28. A semiconductor package according to claim 27, wherein a diameter of the fine particle or a sectional diameter of the fiber has a size substantially the same as a laser light wavelength.

29. A semiconductor package according to claim 28, wherein the fine particle is a glass bead.

30. A semiconductor package according to claim 28, wherein the fiber is a glass fiber.

31. A semiconductor package according to claim 19, wherein said dielectric substrate is of resin to have said semiconductor device flip-chip-mounted on said resin substrate.

32. A semiconductor package according to claim 31, wherein an electromagnetic shielding cap is arranged covering said semiconductor device on the resin substrate.

33. A semiconductor package according to claim 24, wherein said electromagnetic shielding cap is a metal or insulator coated with a metal film.

34. A method for manufacturing a semiconductor package **characterized in that** a thin insulator layer is formed on a quartz substrate mixed with bubbles to provide thereon a semiconductor device and sealed within a container.

35. A method according to claim 34, the thin insulator layer is formed by applying an insulator liquid material on a quartz substrate.

36. A method according to claim 34, the thin insulator layer is formed by laminating an insulator sheet material on a quartz substrate.

37. A method according to claim 34, the thin insulator layer is formed by pressing an insulator sheet material on a quartz substrate.

38. A method according to claim 34, further comprising a step of forming a first electrical interconnect pattern on said thin insulator layer, a step of providing a semiconductor device on a part of the first electrical interconnection pattern, a step of forming a second electrical interconnection pattern on the other surface of said quartz substrate, a step of forming a penetration hole in said quartz substrate by a laser, a step of passing a third electrical interconnection through said penetration hole, and a step of connecting said first electrical interconnection pattern and said second electrical interconnection pattern through a third electrical interconnection.

39. A method according to claim 38, wherein the laser is any one selected from a CO₂ laser, a YAG laser, an excimer laser and a semiconductor diode laser.

40. A method for manufacturing a semiconductor package comprising: a step of forming a penetration hole by a laser in a dielectric substrate containing a substance having a size of a half to 10 times of a laser light wavelength and different in refractive index from a material of said dielectric substrate, a step of forming a first electrical interconnection pattern on a first surface of said dielectric substrate, a step of providing a semiconductor device on a part of the first electrical interconnection pattern, a step of forming a second electrical interconnection pattern on the other surface of said dielectric substrate, a step of forming a penetration hole by a laser in said dielectric substrate, a step of passing a third electrical interconnection through said penetration hole, a step of connecting between said first electrical interconnection pattern and said second electrical interconnection pattern through said third electrical interconnection, and a step of sealing said semiconductor device in a container.

41. A method according to claim 40, wherein the laser is a YAG laser or an excimer laser.

42. A high-frequency circuit having a semiconductor device provided on a substrate and sealed in a container, the high-frequency circuit **characterized in that** said substrate provided with said semiconductor device is a quartz substrate and said quartz substrate contains bubbles in a size of a half to 10 times of a laser light wavelength.

43. A high-frequency circuit having a semiconductor device provided on a substrate and sealed within a container, the high-frequency circuit **characterized in that** said substrate provided with said semiconductor device is a resin substrate and said resin substrate contains a glass bead or a glass fiber.

44. A high-frequency circuit according to claim 43, wherein a diameter of the glass bead or a sectional diameter of the glass fiber has a size substantially the same as a laser light wavelength.
